# EUROPEAN PATENT APPLICATION

(11) **EP 4 807 447 A1**
(43) Date of publication of application: **16.09.2026**
(21) Application number: 24906784.4
(22) Date of filing: 15.01.2024
(51) Int. Cl.: G03F 7/022, G03F 7/004

(54) **POSITIVE PHOTOSENSITIVE RESIN COMPOSITION, INSULATING RESIN FILM, METHOD OF FORMING INSULATING RESIN FILM, AND SEMICONDUCTOR DEVICE**

(30) Priority: 22.12.2023 WO PCT/JP2023/046275; 22.12.2023 WO PCT/JP2023/046274
(71) Applicant: Resonac Corporation, Tokyo 105-7325 (JP)
(72) Inventor: AOKI, Yu, Tokyo 105-7325 (JP); HASHIMOTO, Masahiro, Tokyo 105-7325 (JP); SUZUKI, Teruaki, Tokyo 105-7325 (JP)
(74) Representative: Berggren Oy
(86) International application number: PCT/JP2024/000862
(87) International publication number: WO 2025/134393

(57) **Abstract**

A positive photosensitive resin composition including: (A) an alkali-soluble resin having a phenolic hydroxyl group and an imide group; (B) a photoacid generator; and (C) a thermal crosslinking agent. The photoacid generator contains an o-quinonediazide compound represented by the following Formula (I). Q is a group represented by the following Formula (3a) or the like.

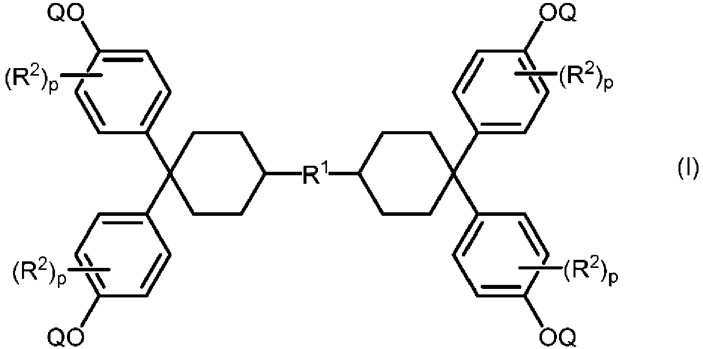

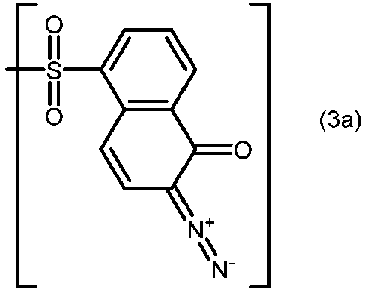

## Description

### Technical Field

The present disclosure relates to a positive photosensitive resin composition, an insulating resin film having a pattern including an opening, a method for forming an insulating resin film having a pattern including an opening, and a semiconductor device.

### Background Art

Patent Literature 1 discloses a positive photosensitive resin composition containing an alkali-soluble resin having an imide bond and a phenolic hydroxyl group as a material capable of forming a surface protective layer or an interlayer insulating layer of a semiconductor element.

### Citation List

### Patent Literature

Patent Literature 1: International Publication WO 2021/261448

### Summary of Invention

### Technical Problem

The present disclosure relates to a positive photosensitive resin composition capable of forming an insulating resin film having a pattern having a favorable shape with high resolution.

### Solution to Problem

The present disclosure includes the following.
[1] A positive photosensitive resin composition including:
   (A) an alkali-soluble resin having a phenolic hydroxyl group and an imide group;
   (B) a photoacid generator being a compound that generates an acid by light; and
   (C) a thermal crosslinking agent being a compound that crosslinks the alkali-soluble resin by heat,
      wherein the photoacid generator comprises an o-quinonediazide compound represented by the following Formula (I): 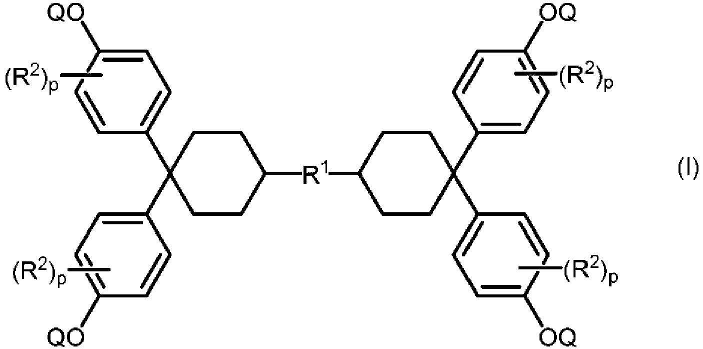
      wherein R¹ is an alkanediyl group having 1 to 3 carbon atoms,
      R² is an alkyl group having 1 to 3 carbon atoms, p is an integer of 0 to 4, and a plurality of R² in the same molecule may be the same or different,
      Q is a group represented by the following Formula (3a), (3b), or (3c): 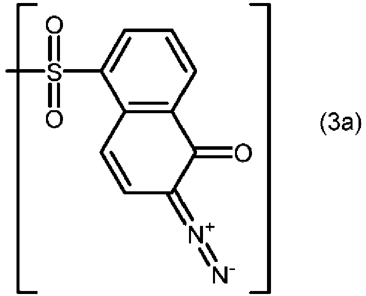 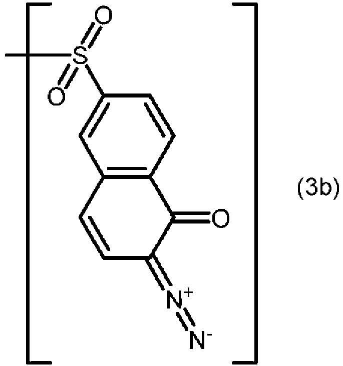 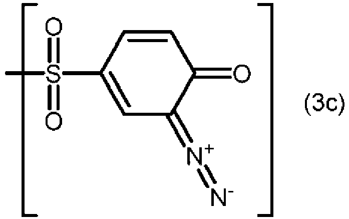
      or a hydrogen atom, wherein a plurality of Q in the same molecule may be the same or different, and at least one of the plurality of Q in the same molecule is a group represented by Formula (3a), (3b), or (3c).
[2] The positive photosensitive resin composition according to [1], wherein
   the alkali-soluble resin comprises a constituent unit that is a group obtained by removing one or more hydrogen atoms from a bisphenolimide compound represented by the following Formula (II): 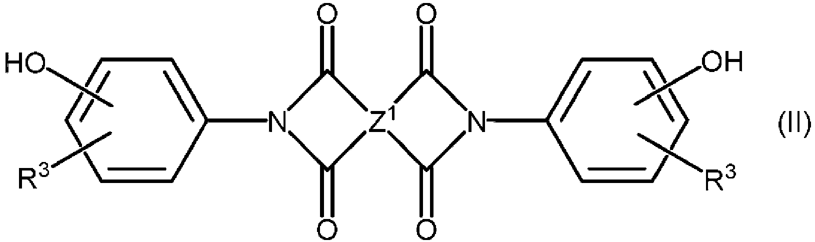
   wherein R³ is a hydrogen atom or an alkyl group having 1 to 3 carbon atoms, and Z¹ is a tetravalent organic group.
[3] The positive photosensitive resin composition according to [1] or [2], wherein the thermal crosslinking agent comprises an alkoxy compound having a plurality of alkoxy groups.
[4] The positive photosensitive resin composition according to any one of [1] to [3], wherein when a portion corresponding to a through-hole having a width of 5 to 20 µm in a photosensitive layer having a film thickness of 5 µm, the photosensitive layer comprising the positive photosensitive resin composition is exposed, and when the photosensitive layer after the exposure is developed under conditions that the through-hole is formed with a tetramethylammonium hydroxide aqueous solution having a concentration of 2.38 mass% at an exposure amount of 1000 mJ/m², a film thickness of the remaining photosensitive layer is 95% or more of a film thickness of the photosensitive layer before exposure.
[5] A method for forming an insulating resin film, the method including:
   exposing a part of a photosensitive layer comprising the positive photosensitive resin composition according to any one of [1] to [4];
   forming an insulating resin film having a pattern including an opening by development for removing a part of the photosensitive layer; and
   heating the insulating resin film.
[6] An insulating resin film comprising a cured product of the positive photosensitive resin composition according to any one of [1] to [4] and having a pattern including an opening.
[7] A semiconductor device including:
   a semiconductor chip; and
   a wiring portion including a conductor wiring layer connected to the semiconductor chip and one or more insulating layers,
   wherein at least a part of the one or more insulating layers is the insulating resin film according to [6].

### Advantageous Effects of Invention

There can be provided a positive photosensitive resin composition capable of forming an insulating resin film having a pattern having a favorable shape with high resolution.

### Brief Description of Drawings

FIG. 1 is a flowchart illustrating an example of a method for forming an insulating resin film having a pattern.
FIG. 2 is a partial cross-sectional view illustrating an example of a semiconductor device.

### Description of Embodiments

The present invention is not limited to the following examples. In the present disclosure, the term "step" includes not only an independent step but also a step that cannot be clearly distinguished from other steps as long as an intended action of the step is achieved. The term "layer" includes not only a structure having a shape formed on the entire surface but also a structure having a shape formed on a part thereof when observed as a plan view. A numerical range using "to" indicates a range including numerical values described before and after "to" as a minimum value and a maximum value. In numerical ranges described in stages in the present specification, an upper limit value or a lower limit value of a numerical range in a certain stage may be replaced with an upper limit value or a lower limit value of a numerical range in another stage. In a numerical range written in the present description, the upper limit value or the lower limit value of the numerical range may be replaced with a value shown in Examples.

### Photosensitive Resin Composition

An example of the photosensitive resin composition includes (A) an alkali-soluble resin having a phenolic hydroxyl group and an imide group, (B) a photoacid generator that is a compound that generates an acid by light, and (C) a thermal crosslinking agent that is a compound that crosslinks the alkali-soluble resin by heat. The photosensitive resin composition according to the present disclosure can function as a positive photosensitive resin composition based on a change in solubility in an alkaline developer due to exposure. In addition, the film containing the photosensitive resin composition according to the present disclosure can be thermally cured mainly by a crosslinking reaction between a thermal crosslinking agent and an alkali-soluble resin to form an insulating resin film which is a cured film containing a cured product of the photosensitive resin composition.

### (A) Alkali-Soluble Resin

The alkali-soluble resin may be a polymer having a constituent unit having a phenolic hydroxyl group and an imide group. The alkali-soluble resin may have a cyclic imide group containing an imide group and a hydrocarbon group that forms a cyclic structure together with the imide group. The cyclic imide group may be a 5-membered ring. The alkali-soluble resin may contain an aromatic group forming a condensed ring with a cyclic imide group, an alicyclic group, or both of them.

The alkali-soluble resin having a cyclic imide group may be, for example, a polymer containing a constituent unit that is a group obtained by removing one or more hydrogen atoms from a bisphenolimide compound represented by the following Formula (II). In the Formula (II), R³ is a hydrogen atom or an alkyl group having 1 to 3 carbon atoms (for example, a methyl group), and Z¹ is a tetravalent organic group. The alkali-soluble resin having a constituent unit derived from the bisphenolimide compound represented by the Formula (II) may be a novolak resin containing a constituent unit derived from the bisphenolimide compound represented by the Formula (II).

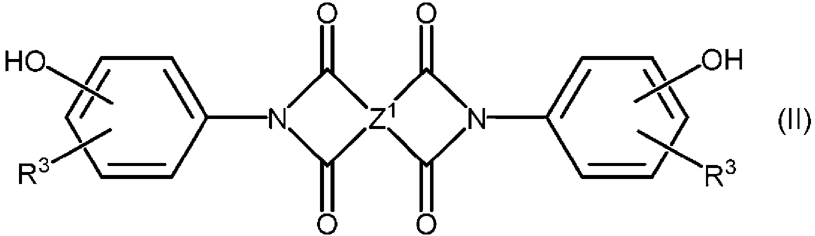

Z¹ may be one cyclic hydrocarbon group optionally having a substituent (for example, an alkyl group having 1 to 3 carbon atoms), or a group having two or more cyclic hydrocarbon groups optionally having a substituent (for example, an alkyl group having 1 to 3 carbon atoms) and a divalent organic group or a covalent bond bonding these groups.

Examples of the cyclic hydrocarbon group in Z¹ include groups obtained by removing one or more hydrogen atoms from the following cyclic hydrocarbon compound.

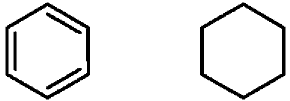

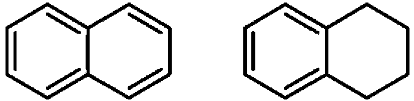

The divalent organic group bonding two cyclic hydrocarbon groups in Z¹ may be, for example, a divalent group selected from the group consisting of an oxy group (-O-), a thio group (-S-), a carbonyl group, an alkylene group having 1 to 3 carbon atoms, a phenylene group, an alkylphenylene group, and a combination thereof. Examples of the alkylene group having 1 to 3 carbon atoms include a methylene group, an ethylene group, an ethylidene group, a propan-1,3-diyl group, a propan-1,1-diyl group, and a propan-2,2-diyl group. Specific examples of the divalent organic group bonding two cyclic hydrocarbon groups in Z¹ include the following in addition to an alkylene group having 1 to 3 carbon atoms.

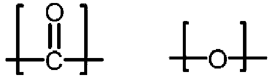

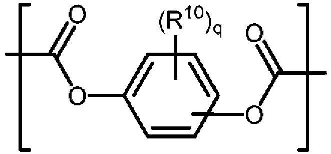

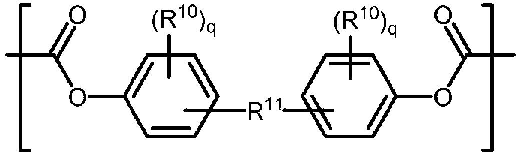

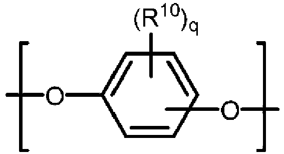

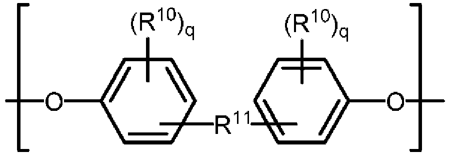

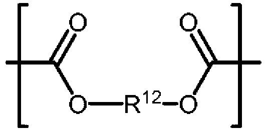

In these formulae, R¹⁰ represents an alkyl group having 1 to 3 carbon atoms (for example, a methyl group), and a plurality of R¹⁰ in the same molecule may be the same or different. q represents an integer of 0 to 4, and a plurality of q in one formula may be the same or different. R¹¹ represents an alkylene group (for example, a propan-2,2-diyl group or a methylene group), an oxy group, a thio group, or a direct bond. R¹² represents an alkylene group (for example, an ethane-1,2-diyl group).

The bisphenolimide compound may be a compound represented by the following Formula (IIA), (IIB), or (IIC). R³ in the formulae (IIA), (IIB), and (IIC) is defined as for R³ in the Formula (II). R⁴ in the Formula (IIB) represents a direct bond (covalent bond) or a divalent organic group. Examples of the divalent organic group as R⁴ include the same ones as those mentioned as the divalent organic group that bonds two cyclic hydrocarbon groups in Z¹. R⁵ in the Formula (IIC) represents a hydrogen atom or an alkyl group having 1 to 3 carbon atoms (for example, a methyl group).

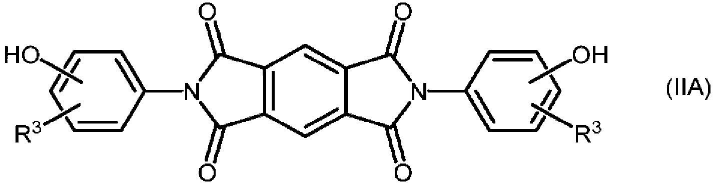

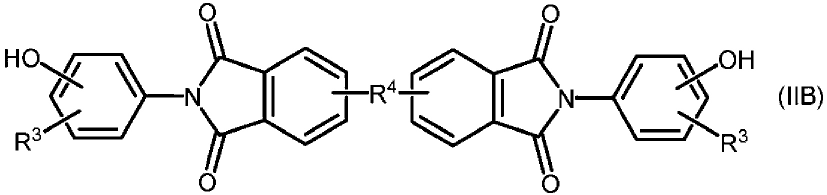

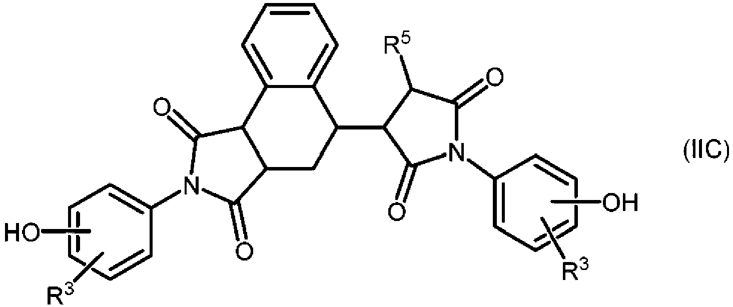

The Formula (IIB) may be, for example, the following Formula (IIB'). R³ and R⁴ in the Formula (IIB') are defined as for R³ and R⁴ in the Formula (IIB).

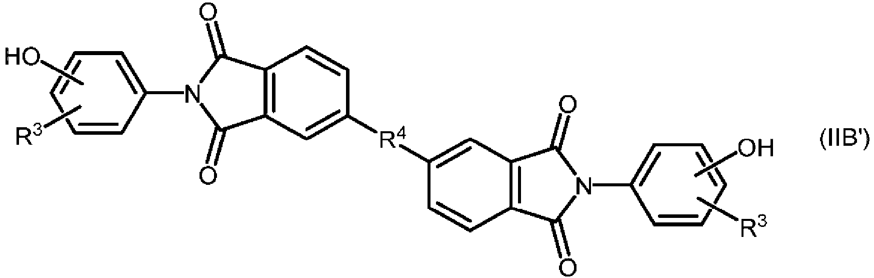

In the bisphenolimide compound represented by the Formula (IIA), (IIB), or (IIB'), from the viewpoint of improving solubility in a solvent, at least one of two phenolic hydroxyl groups may be bonded to an imide group at a meta position or an ortho position. Examples of the bisphenolimide compound represented by the Formula (IIA) in which a phenolic hydroxyl group is bonded to an imide group at a meta position or an ortho position include compounds represented by the following Formula (IIA-1), (IIA-2), (IIA-3), or (IIA-4). Examples of the bisphenolimide compound represented by the Formula (IIB) in which a phenolic hydroxyl group is bonded to an imide group at a meta position or an ortho position include compounds represented by the following Formula (IIB-1), (IIB-2), (IIB-3), or (IIB-4). These compounds tend to have an excellent balance between solubility and mechanical strength. R⁴ in the formulae (IIB-1), (IIB-2), (IIB-3), and (IIB-4) is defined as for R⁴ in the Formula (IIB).

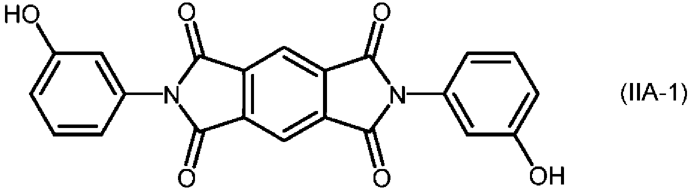

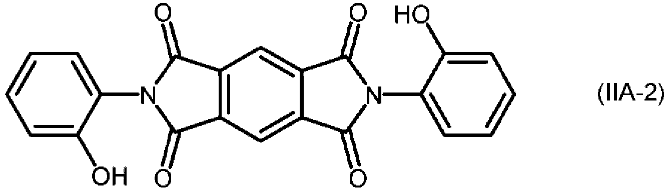

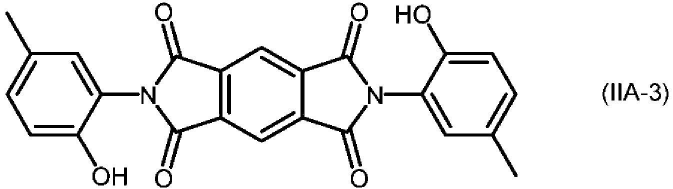

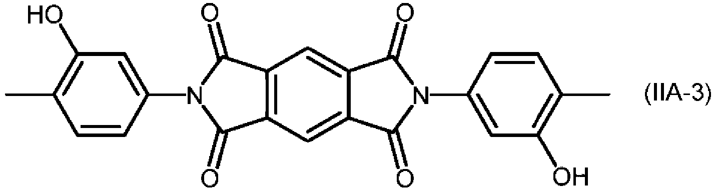

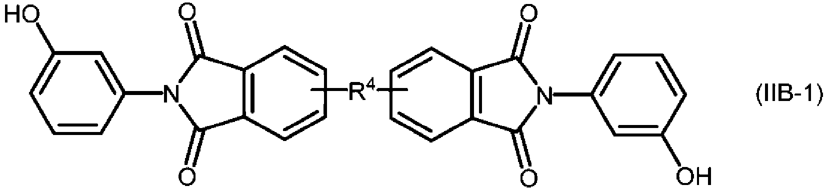

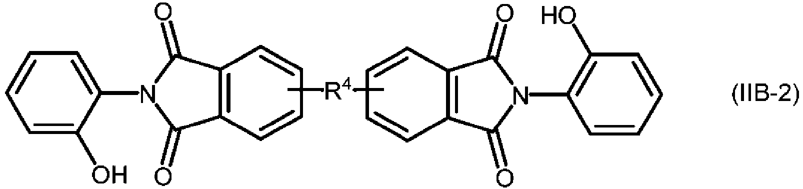

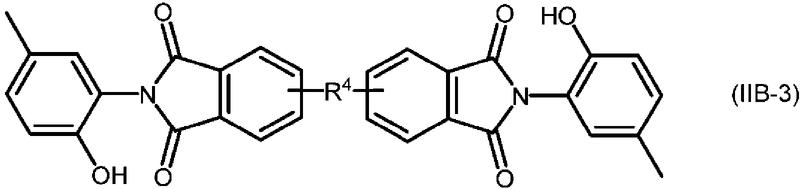

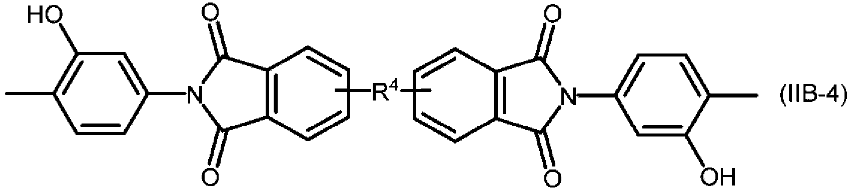

The novolak resin containing a constituent unit derived from a bisphenolimide compound represented by the Formula (II) may have a polymerized chain in which a constituent unit derived from a phenol compound selected from phenol, o-cresol, m-cresol, and p-cresol or a bisphenolimide compound and a constituent unit derived from a reactive compound selected from an aldehyde compound, a compound having a plurality of methoxymethyl groups, and a compound having a plurality of hydroxymethyl groups are alternately bonded. The constituent unit derived from the bisphenolimide compound may be a residue obtained by removing one or more hydrogen atoms from an aromatic group (particularly, a benzene ring to which a phenolic hydroxyl group is bonded) in the bisphenolimide compound. The constituent unit derived from the bisphenolimide compound may be bonded to another constituent unit at a position of an ortho position or a para position with respect to the phenolic hydroxyl group.

The aldehyde compound constituting the novolak resin may be formaldehyde. The compound having a plurality of methoxymethyl groups may be a compound having an aromatic ring (for example, a benzene ring) to which a methoxymethyl group is bonded. The compound having a plurality of hydroxymethyl groups may be a compound having an aromatic ring (for example, a benzene ring) to which a hydroxymethyl group is bonded. Examples of the compound having a plurality of methoxymethyl groups include compounds represented by the following Formula (21) or (22). R¹⁰ in these formulae represents an alkyl group having 1 to 3 carbon atoms (for example, a methyl group). A plurality of R¹⁰ in the same molecule may be the same or different. p represents an integer of 0 to 4, and q and r each independently represent an integer of 0 to 4. The compound having a plurality of methoxymethyl groups may be bis(methoxymethyl)biphenyl, dimethoxymethylbenzene, or a combination thereof. Examples of compounds having a plurality of hydroxymethyl groups include 2,6-bis(hydroxymethyl)-p-cresol.

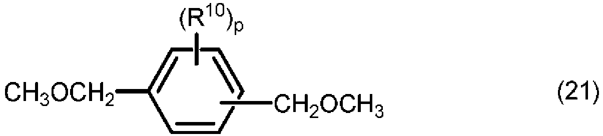

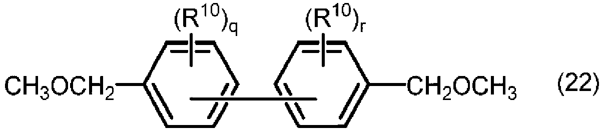

The residue derived from formaldehyde is usually a methylene group. The residue derived from the compound having two or more methoxymethyl groups can be, for example, a divalent group represented by the following Formula (21A) or (22B). R¹⁰, p, q, and r in the formulae (21A) and (22B) are defined as in R¹⁰, p, q, and r in the formulae (21) and (22).

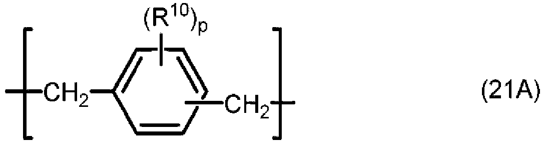

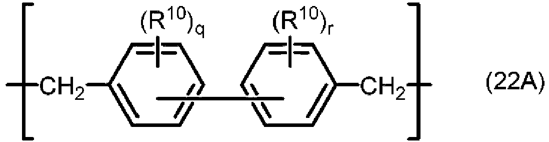

In the phenol compound that reacts with the aldehyde compound or the like in the reaction for producing the novolak resin, the proportion of the bisphenolimide compound may be 10 mol% or more and 100 mol% or less, 20 mol% or more and 100 mol% or less, 30 mol% or more and 100 mol% or less, or 40 mol% or more and 100 mol% or less based on the total amount of the phenol compound. When the ratio of the bisphenolimide compound is large, it is easy to obtain particularly excellent effects in terms of the good shape and high resolution of the insulating resin film. From the same viewpoint, the ratio of the bisphenolimide compound may be 50 mol% or more, 60 mol% or more, 70 mol% or more, 80 mol% or more, or 90 mol% or more, or may be substantially 100 mol%, based on the total amount of the phenol compound.

The novolak resin that is an alkali-soluble resin can be synthesized, for example, by a method according to a general phenol novolak resin or cresol novolak resin synthesis method.

The weight average molecular weight (Mw) of the alkali-soluble resin may be 1000 to 500000, 2000 to 400000, 3000 to 350000, or 5000 to 300000 from the viewpoint of balance among solubility in an aqueous alkali solution, photosensitivity characteristics, and mechanical strength of the insulating resin film. In the present disclosure, the weight average molecular weight is a converted value by a standard polystyrene calibration curve measured by a gel permeation chromatography (GPC) method.

### (B) Photoacid Generator

The photoacid generator contains an o-quinonediazide compound represented by the following Formula (I): 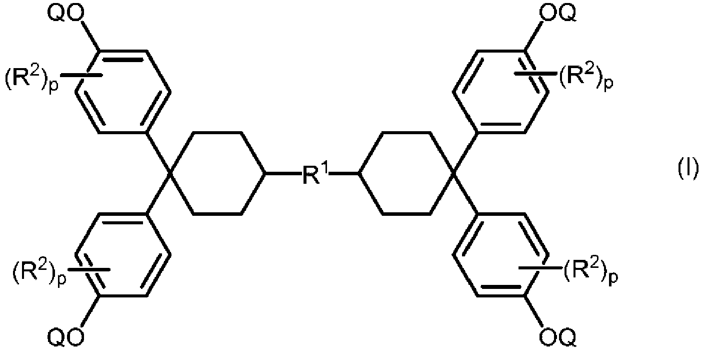 In the Formula (I), R¹ is an alkanediyl group having 1 to 3 carbon atoms, R² is an alkyl group having 1 to 3 carbon atoms, p is an integer of 0 to 4, and a plurality of R² in the same molecule may be the same or different. Q in the Formula (I) is a group represented by the following Formula (3a), (3b), or (3c), or a hydrogen atom. A plurality of Q in the same molecule may be the same or different, and at least one of the plurality of Q in the same molecule is a group represented by the Formula (3a), (3b), or (3c). R² may be a methyl group. p may be 0 to 3, 0 to 2, 0 to 1, or 0. Two or more or three or more of four Q in the same molecule may be a group represented by the Formula (3a), (3b), or (3c).

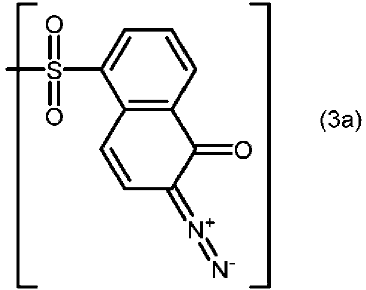

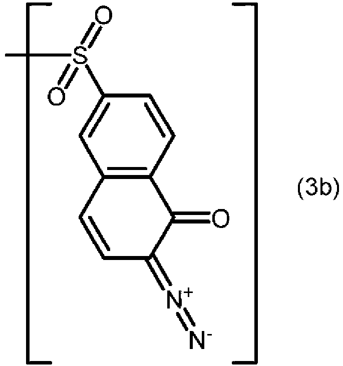

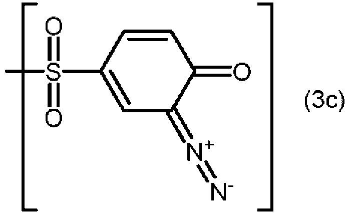

The combination of the alkali-soluble resin having a phenolic hydroxyl group and an imide group and the o-quinonediazide compound represented by the Formula (I) can contribute to forming an insulating resin film having a pattern of a favorable shape with high resolution.

The o-quinonediazide compound represented by the Formula (I) may be a compound represented by the following Formula (IA). R², Q, and p in the Formula (IA) are defined as for R², Q, and p in the Formula (I).

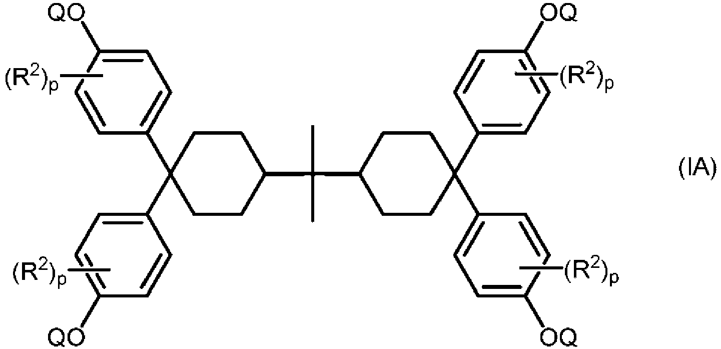

The photoacid generator may further contain an o-quinonediazide compound represented by the following Formula (I). The ratio of the o-quinonediazide compound represented by the Formula (I) in the photoacid generator may be 50 mass% or more, 60 mass% or more, 70 mass% or more, 80 mass% or more, or 90 mass% or more and 100 mass% or less, or may be substantially 100 mass%.

The content of the photoacid generator or the o-quinonediazide compound represented by the Formula (I) may be 1 to 50 mass%, 3 to 35 mass%, or 5 to 20 mass% with respect to the content of the alkali-soluble resin of the component (A) from the viewpoint of good sensitivity.

### (C) Thermal Crosslinking Agent

The thermal crosslinking agent of the component (C) contains one or more compounds that crosslink the alkali-soluble resin by heat. The compound constituting the thermal crosslinking agent may have a plurality of functional groups capable of reacting with the alkali-soluble resin and bonding to the molecular chain of the alkali-soluble resin. Examples of the functional group include an alkoxy group, an epoxy group, and an oxazoline group. The thermal crosslinking agent may include an alkoxy compound having a plurality of alkoxy groups.

It is considered that the alkoxy compound that can be used as the thermal crosslinking agent mainly functions as a thermal crosslinking agent that crosslinks the molecular chain of the alkali-soluble resin by a reaction between an aromatic group (phenylene group) to which a phenolic hydroxyl group is bonded and an alkoxy group. The number of alkoxy groups in the alkoxy compound may be 2 or more, 3 or more, or 4 or more, and may be 20 or less, 15 or less, or 10 or less.

At least a part of two or more alkoxy groups of the alkoxy compound may be a methoxy group. In other words, the alkoxy compound may have a plurality of methoxy groups. The alkoxy compound may have four or more methoxy groups.

The alkoxy compound may have a cyclic group obtained by removing one or more hydrogen atoms from benzene, 1,3,5-triazine, or glycoluril, 2-imidazolidinone, or urea, and an alkoxyalkyl group (for example, methoxymethyl group, 1,3-dimethoxypropan-2-yl group) may be bonded to the cyclic group. The alkoxy compound having a cyclic group (benzene ring) obtained by removing a hydrogen atom from benzene may have a phenolic hydroxyl group bonded to the cyclic group. In the present disclosure, a compound having an alkoxy group and a phenolic hydroxyl group may be regarded as a thermal crosslinking agent of the component (C) instead of an alkali-soluble resin. The alkoxy compound having an alkoxy group and a phenolic hydroxyl group can contribute to improvement of the sensitivity of the photosensitive resin composition.

The weight average molecular weight of the alkoxy compound may be 3000 or less, 2000 or less, 1500 or less, or 100 or more from the viewpoint of the balance among solubility in an alkaline developer, photosensitivity characteristics, and mechanical strength.

Specific examples of the alkoxy compound having a phenolic hydroxyl group include compounds represented by the following Formula (41), (42), (43), (44), (45), or (46). Specific examples of the alkoxy compound having a cyclic group obtained by eliminating one or more hydrogen atoms from 1,3,5-triazine, glycoluril, 2-imidazolidinone, or urea include compounds represented by the following Formula (47), (48), (49), or (50).

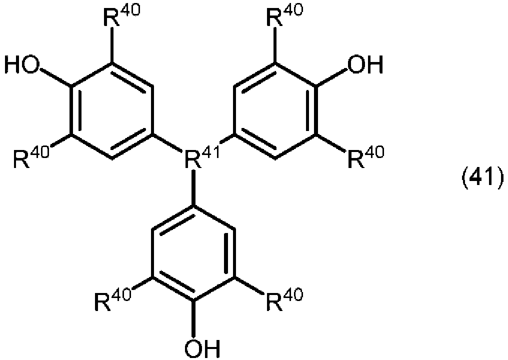

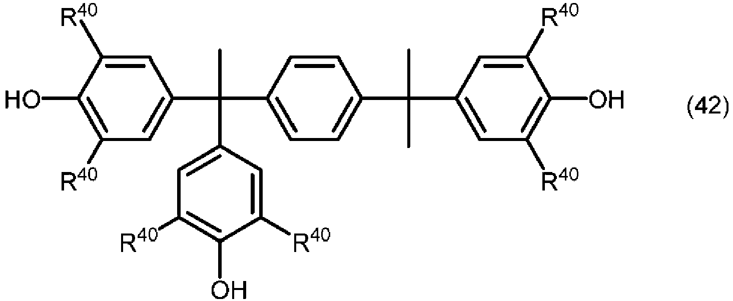

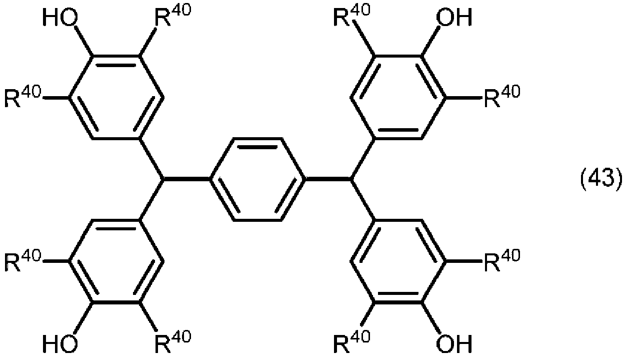

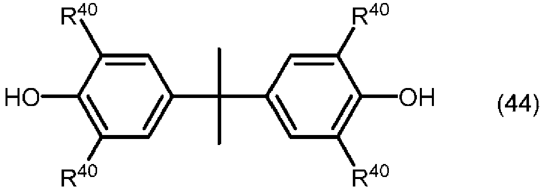

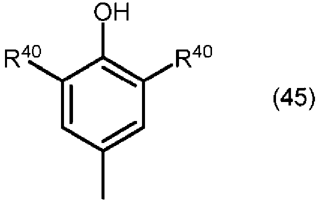

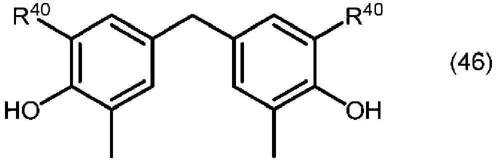

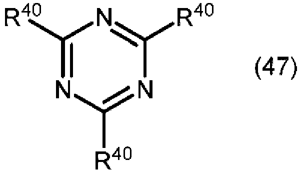

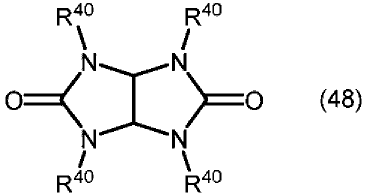

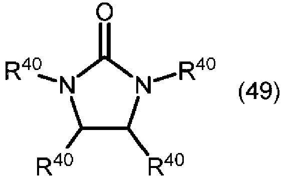

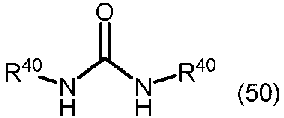

In the formulae (41) to (50), R⁴⁰ represents an alkoxyalkyl group, and a plurality of R⁴⁰ in the same molecule may be the same or different. R⁴⁰ may be a methoxyalkyl group or a dimethoxyalkyl group, and examples thereof include a methoxymethyl group (-CH₂OCH₃) and a 1,3-dimethoxypropan-2-yl group represented by the following formula.

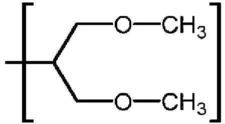

The content of the thermal crosslinking agent (or the alkoxy compound) may be 1 to 70 mass%, 2 to 50 mass%, or 3 to 40 mass% with respect to the content of the alkali-soluble resin of the component (A) from the viewpoint of the heat resistance and the warpage suppression of the insulating resin film (cured film).

In the photosensitive resin composition, the total content of the alkali-soluble resin (A), the photoacid generator (B), and the thermal crosslinking agent (C) may be 50 mass% or more, 60 mass% or more, 70 mass% or more, 80 mass% or more, 90 mass% or more, or 95 mass% or more, or may be 100 mass% or less, based on the amount of the photosensitive resin composition. When the photosensitive resin composition contains a solvent, the amount of the photosensitive resin composition herein is the amount excluding the solvent.

### Other Components

In addition to the components (A) to (C), the photosensitive resin composition may further contain other components such as an elastomer, an adhesion aid, a solvent, a compound that generates an acid by heating, a dissolution accelerator, a dissolution inhibitor, a Cu rust inhibitor, a coupling agent, and a surfactant, and a leveling agent. The photosensitive resin composition may further contain an alkali-soluble resin that does not correspond to the component (A), separately from the component (A).

The elastomer may be, for example, one or more selected from a styrene elastomer, an olefin elastomer, a urethane elastomer, a polyester elastomer, a polyamide elastomer, an acrylic elastomer, and a silicone elastomer.

The elastomer may be an acrylic elastomer containing a (meth)acrylic acid alkyl ester as a monomer unit. The (meth)acrylic acid alkyl ester may have an alkyl group having 1 to 20 carbon atoms. The acrylic elastomer may further contain one or more acrylic monomers selected from an ester between (meth)acrylic acid and an aliphatic alcohol having an amino group, a (meth)acrylic acid alkyl ester having a hydroxyalkyl group having 4 to 20 carbon atoms, and (meth)acrylic acid as monomer units. The content of the elastomer may be 0 to 50 mass%, 0.5 to 50 mass%, 1 to 30 mass%, or 2 to 20 mass% with respect to the amount of the alkali-soluble resin. The "(meth)acrylic acid" means acrylic acid or methacrylic acid.

The adhesion aid may include a nitrogen-containing aromatic compound, and examples of which include 1H-tetrazole, 5-aminotetrazole, 5-phenyltetrazole, and 5-methyltetrazole. The content of the adhesive aid may be 0 to 20 mass%, 0.01 to 20 mass%, 0.015 to 10 mass%, or 0.02 to 7 mass% with respect to the content of the alkali-soluble resin of the component (A).

Examples of solvents include γ-butyrolactone, ethyl lactate, propylene glycol monomethyl ether acetate, benzyl acetate, n-butyl acetate, ethoxyethyl propionate, 3-methyl methoxypropionate, N-methyl-2-pyrrolidone, N,N-dimethylformamide, N,N-dimethylacetamide, dimethyl sulfoxide, hexamethylphosphorylamide, tetramethylene sulfone, diethyl ketone, diisobutyl ketone, methyl amyl ketone, cyclohexanone, propylene glycol monomethyl ether, propylene glycol monopropyl ether, propylene glycol monobutyl ether, and dipropylene glycol monomethyl ether. These solvents can be used alone or in combination of two or more kinds thereof. The solvent may include ethyl lactate, γ-butyrolactone, or a combination thereof. In the photosensitive resin composition containing a solvent, the concentration of components (solid content) other than the solvent may be 1 to 80 mass% based on the mass of the photosensitive resin composition containing a solvent.

The compound that generates an acid by heating promotes a thermal crosslinking reaction between the alkali-soluble resin and the oxazoline compound or the alkoxy compound, and as a result, the heat resistance of the cured film can be further improved. Compounds that produce acids upon heating can also contribute to improved resolution. Examples of the compound that produces an acid by heating include a salt formed from a strong acid such as an onium salt and a base, and imide sulfonate. The content of the compound that produces an acid by heating may be 0 to 30 mass%, 0.1 to 30 mass%, 0.2 to 20 mass%, or 0.5 to 10 mass% with respect to the content of the alkali-soluble resin of the component (A).

The dissolution accelerator is a component that increases the dissolution rate of the exposed portion in the developer, and can contribute to improvement of sensitivity and resolution. The dissolution accelerator may contain a compound having a carboxy group, a sulfo group, or a sulfonamide group. The content of the dissolution accelerator may be 0 to 30 mass% or 0.01 to 30 mass% with respect to the content of the alkali-soluble resin of the component (A).

The dissolution inhibitor is a compound that inhibits the dissolution of an exposed portion in an alkaline aqueous solution, and is used to control the film thickness after development, development time, and contrast. Examples of dissolution inhibitors include diphenyliodonium nitrate, bis(p-tert-butylphenyl)iodonium nitrate, diphenyliodonium bromide, diphenyliodonium chloride, and diphenyliodonium iodide. The content of the dissolution inhibitor may be 0 to 20 mass%, 0.01 to 20 mass%, 0.01 to 15 mass%, or 0.05 to 10 mass% with respect to the content of the alkali-soluble resin of the component (A).

The coupling agent may include an organosilane compound (silane coupling agent), an aluminum chelate compound, or a combination thereof. Examples of commercially available products of the organosilane compound include KBM-403, KBM-803, and KBM-903 (trade name, manufactured by Shin-Etsu Chemical Co., Ltd.). The content of the coupling agent may be 0 to 20 mass%, 0.1 to 20 mass%, or 0.5 to 10 mass% with respect to the content of the alkali-soluble resin of the component (A).

Examples of surfactants or leveling agents include polyoxyethylene lauryl ether, polyoxyethylene stearyl ether, polyoxyethylene oleyl ether, and polyoxyethylene octylphenol ether. Examples of commercial products include Megaface F-171, F-565, and RS-78 (trade name, manufactured by DIC Corporation). The content of the surfactant or the leveling agent may be 0 to 5 mass%, 0.001 to 5 mass%, or 0.01 to 3 mass% with respect to the content of the alkali-soluble resin of the component (A).

### Method for Forming Insulating Resin Film Having Pattern

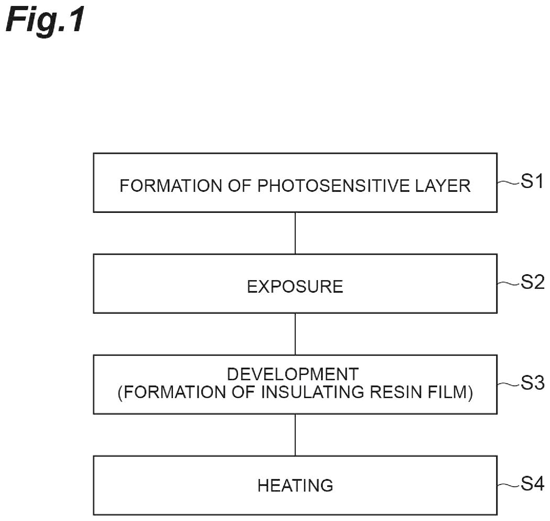

An insulating resin film having a pattern including an opening can be formed by photolithography using the photosensitive resin composition according to the present disclosure. FIG. 1 is a flowchart illustrating an example of a method for forming an insulating resin film having a pattern including an opening. The method illustrated in FIG. 1 includes step S1 of forming a photosensitive layer containing a photosensitive resin composition, step S2 of exposing a part of the photosensitive layer, step S3 of forming an insulating resin film having a pattern including an opening by development for removing a part of the photosensitive layer, and step S4 of heating the insulating resin film.

The photosensitive layer containing the photosensitive resin composition is formed on any substrate such as a glass substrate, a semiconductor substrate, a metal oxide insulator substrate (for example, TiO₂, SiO₂), or a silicon nitride substrate. The photosensitive layer is formed, for example, by a method including applying a positive photosensitive resin composition containing a solvent onto a substrate and removing the solvent from a coating film. The coating film may be heated to remove the solvent. The thickness of the photosensitive layer may be 0.1 to 40 µm.

A part of the photosensitive layer is exposed by irradiation with an actinic ray through a mask. The actinic ray may be ultraviolet light, visible light, or radiation, and may be g-line, h-line, i-line, or a combination thereof.

A resin film (insulating resin film) having a pattern including an opening is formed by development for removing a part of the photosensitive layer. A developer may be used for development. Examples of development using a developer include shower development, spray development, immersion development, and paddle development. The developed resin film (insulating resin film) may be washed with water or the like.

The developer may be an aqueous alkali solution. The aqueous alkali solution may contain one or more bases selected from sodium carbonate, sodium hydroxide, potassium hydroxide, sodium silicate, ammonia, ethylamine, diethylamine, triethylamine, triethanolamine, and tetramethylammonium hydroxide (TMAH). The concentration of the base in the aqueous alkali solution may be 0.1 to 10 mass% based on the mass of the aqueous alkali solution. The developer may include an alcohol or a surfactant.

When a portion corresponding to a through-hole having a width of 5 to 20 µm in a photosensitive layer having a film thickness of 5 µm containing the positive photosensitive resin composition is exposed, and when the photosensitive layer after the exposure is developed under conditions that the through-hole is formed with a tetramethylammonium hydroxide aqueous solution having a concentration of 2.38 mass% at an exposure amount of 1000 mJ/m², a film thickness of the remaining photosensitive layer may be 95% or more of a film thickness of the photosensitive layer before exposure.

By heating the resin film (insulating resin film) which is a photosensitive layer remaining after development, an insulating resin film which is a resin film containing a thermally cured product of the photosensitive resin composition is formed mainly by a reaction between the alkali-soluble resin and the thermal crosslinking agent. The heating temperature may be 300°C or lower, 270°C or lower, or 250°C or lower, or may be 160°C or higher. The heating time may be, for example, 0.5 hours or more and 5 hours or less.

The resin film (insulating resin film) can be heated using, for example, a heating device such as a quartz tube furnace, a hot plate, rapid thermal annealing, a vertical diffusion furnace, an infrared curing furnace, an electron beam curing furnace, a microwave curing furnace, a microwave curing device, or a variable frequency microwave curing device. The heating atmosphere may be, for example, an air atmosphere or an inert gas atmosphere containing nitrogen or the like.

### Semiconductor Device

The insulating resin film can be, for example, an insulating layer constituting a wiring portion of a semiconductor device. The semiconductor device may include a semiconductor chip and a wiring portion (rewiring portion) including a conductor wiring layer connected to the semiconductor chip and one or more insulating layers, and at least a part of the one or more wiring layers may be an insulating resin film containing a cured product of the photosensitive resin composition according to the present disclosure.

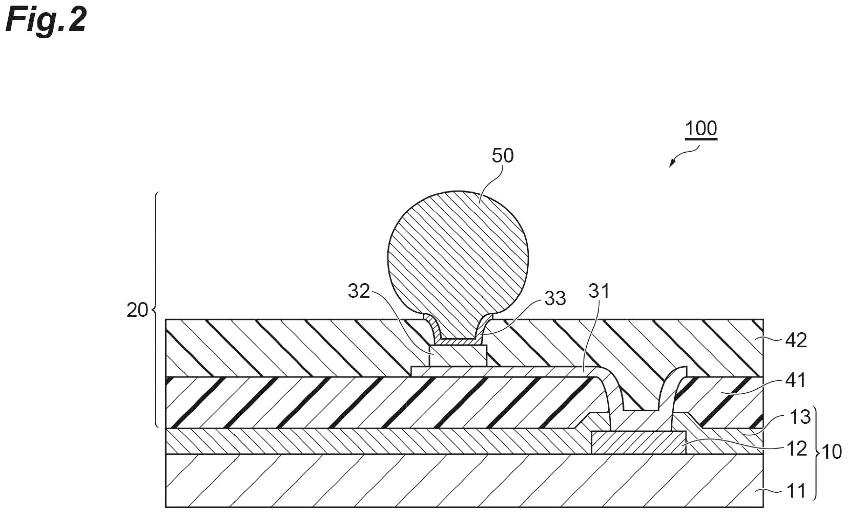

FIG. 2 is a partial cross-sectional view illustrating an example of a semiconductor device having an insulating layer. A semiconductor device 100 illustrated in FIG. 2 includes a semiconductor chip 10 and a wiring portion 20 provided on the semiconductor chip 10. The wiring portion 20 includes a conductor wiring layer 31 connected to the semiconductor chip 10, a surface protective layer 41, a cover coating layer 42, and a conductive ball 50. The semiconductor device 100 may be a semiconductor package having a configuration of a wafer level package (WLP). The surface protective layer 41 and the cover coating layer 42 are stacked in this order from the semiconductor chip 10 side, and the conductive ball 50 is provided outside the cover coating layer 42. The surface protective layer 41 and the cover coating layer 42 are insulating layers, and one or both of them may be an insulating resin film containing a cured product of the photosensitive resin composition according to the present disclosure.

The semiconductor chip 10 includes a chip main body portion 11 having a circuit surface, a pad portion 12 provided on the circuit surface of the chip main body portion 11, and a protective film 13 having a pattern including an opening through which the pad portion 12 is exposed. The conductor wiring layer 31 of the wiring portion 20 is a rewiring layer connected to the pad portion 12, and extends to a portion inside the conductive ball 50 between the surface protective layer 41 and the cover coating layer 42. A connection surface 32 for connecting to the conductive ball 50 is provided on an end portion of the conductor wiring layer 31. A barrier metal 33 is provided between the connection surface 32 and the conductive ball 50. The pad portion 12, the conductor wiring layer 31, the connection surface 32, the barrier metal 33, and the conductive ball 50 are electrically connected in this order.

The wiring portion (rewiring portion) of the semiconductor device may include a multilayer conductor wiring layer, and an insulating resin film containing a cured product of the photosensitive resin composition according to the present disclosure may be provided as an interlayer insulating layer provided between adjacent conductor wiring layers. In the semiconductor device, the interlayer insulating layer, the surface protective layer, or both of them may be an insulating resin film containing a cured product of the photosensitive resin composition according to the present disclosure.

The semiconductor device may be a memory. Examples of the electronic device including the semiconductor device according to the present disclosure include a mobile phone, a smartphone, a tablet terminal, a personal computer, and a hard disk suspension.

### Examples

The present invention is not limited to the following Examples.

### 1. Source Materials

The following source materials were prepared.
(A) Alkali-Soluble Resin
   A1: novolak resin having a phenolic hydroxyl group and an imide group (acid-catalyzed reaction product of bis(o-hydroxy-p-methylphenyl)4,4'-oxyphthalimide with 1,4-bismethoxymethylbenzene, weight-average molecular weight: 270000)
   A2: novolak resin having a phenolic hydroxyl group and an imide group (acid-catalyzed reaction product of bis(o-hydroxy-p-methylphenyl)4,4'-biphthalimide with 1,4-bismethoxymethylbenzene, weight-average molecular weight: 13000)
   A3: novolak resin having a phenolic hydroxyl group and an imide group (acid-catalyzed reaction product of bis(o-hydroxyphenyl)4,4'-oxyphthalimide with 1,4-bismethoxymethylbenzene, weight-average molecular weight: 42000)
   A4: novolak resin having a phenolic hydroxyl group and an imide group (acid-catalyzed reaction products of bis(m-hydroxyphenyl)pyrrolimethimide, o-cresol, and p-cresol with 1,4-bismethoxymethylbenzene and formaldehyde, molar ratio: bis(m-hydroxyphenyl)pyrrolimethimide/o-cresol/p-cresol/1,4-bismethoxymethylbenzene/formaldehyde = 10/60/30/30/70, weight average molecular weight: 150000)
   A'1: p-hydroxystyrene-styrene copolymer (molar ratio: p-hydroxystyrene/styrene = 85/15, weight average molecular weight: 10000, manufactured by Maruzen Petrochemical Co., Ltd., trade name "CST 85")
(B) Photoacid Generator
   B1: 1-naphthoquinone-2-diazide-5-sulfonic acid ester of 2,2-bis [4,4-bis(4-hydroxyphenyl)cyclohexyl]propane (compound represented by the Formula (10) wherein Q is a group represented by the Formula (3a), esterification rate: about 90%, manufactured by Toyo Gosei Co., Ltd., trade name "TEKP-250") 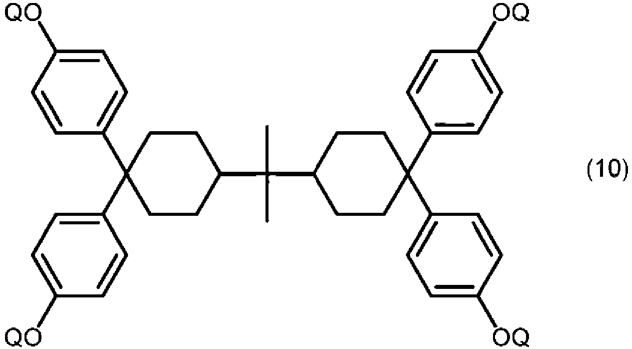
   B'1: 1-naphthoquinone-2-diazide-5-sulfonic acid ester of 1,1-bis(4-hydroxyphenyl)-1-[4-{1-(4-hydroxyphenyl)-1-methylethyl}phenyl]ethane (compound represented by the Formula (11), wherein Q is a group represented by the Formula (3a), esterification ratio: about 63%, manufactured by Daito Chemix Corporation, trade name "PA 28") 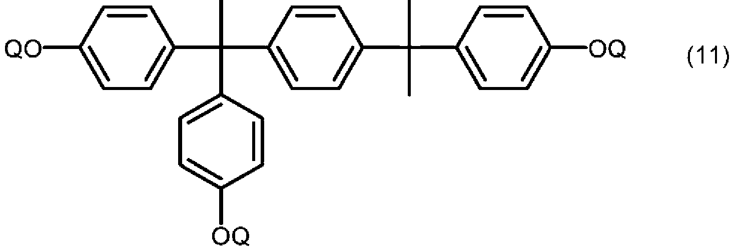
(C) Thermal Crosslinking Agent
   C1: 4,4'-[1-[4-[1-[4-hydroxy-3,5-bis(methoxymethyl)phenyl]-1-methylethyl]phenyl]ethylidene]bis[2,6-bis(methoxymethyl)phenol] (compound represented by the Formula (42), wherein R⁴⁰ is a methoxymethyl group, manufactured by Honshu Chemical Industry Co., Ltd., trade name "HMOM-TPPA")
   C2: 2,2-bis(4-hydroxy-3,5-dimethoxymethyl-phenyl)propane (compound represented by the Formula (44), wherein R⁴⁰ is a methoxymethyl group, manufactured by ASAHI YUKIZAI CORPORATION, trade name "TMX-BIP")
(D) Silane Coupling Agent
   D1: 3-glycidyloxypropyltrimethoxysilane (manufactured by Shin-Etsu Chemical Co., Ltd., trade name "KBM 403")

### 2. Photosensitive Resin Composition

Each component was mixed with a solvent at a mixing ratio (parts by mass) shown in Table 1. When the alkali-soluble resin was A1, A2, or A3, the solvent was γ-butyrolactone. When the alkali-soluble resin was A4 or A'1, the solvent was ethyl lactate. The mixture was filtered under pressure through a 0.2 µm-pore polytetrafluoroethylene filter to prepare a photosensitive resin composition.

### 3. Evaluation

### Via resolution

The photosensitive resin composition was applied onto a silicon substrate by spin coating. The coating film was heated at 120°C for 3 minutes to remove the solvent, thereby forming a photosensitive layer having a film thickness of 5 to 6 µm. Then, using an i-line stepper (manufactured by Canon Inc., trade name "FPA-3000iW"), the photosensitive layer was subjected to reduction projection exposure with i-line (365 nm) through a mask having a pattern corresponding to through-holes of different widths stepwise in a range of 1 µm to 100 µm. The exposure amount of i-line was 1000 mJ/cm². After the exposure, a part of the photosensitive layer was removed by development using a tetramethylammonium hydroxide (TMAH) aqueous solution having a concentration of 2.38 mass%. The remaining insulating resin film as a photosensitive layer was washed with water. The insulating resin film was observed, and the minimum width of the formed through-holes was recorded as the via resolution. A small via resolution means that the resolution is good.

### Pattern Angle

The photosensitive resin composition was applied onto a silicon substrate by spin coating. The coating film was heated at 120°C for 3 minutes to remove the solvent, thereby forming a photosensitive layer having a film thickness of 5 to 6 µm. Then, using an i-line stepper (manufactured by Canon Inc., trade name "FPA-3000iW"), the photosensitive layer was subjected to reduction projection exposure with i-line (365 nm) through a mask having a pattern corresponding to a through-hole having a width of 5 µm. The exposure amount of i-line was 1000 mJ/cm². After the exposure, a part of the photosensitive layer was removed by development using a TMAH aqueous solution having a concentration of 2.38 mass%. The remaining insulating resin film as a photosensitive layer was washed with water. The insulating resin film was observed, and the angle of the wall surface of the through-hole with respect to the surface of the silicon substrate was recorded as a pattern angle. A large pattern angle means that a pattern having a good shape is formed.

### Development Residual Film Ratio

The photosensitive resin composition was applied onto a silicon substrate by spin coating. The coating film was heated at 120°C for 3 minutes to remove the solvent, thereby forming a photosensitive layer having a film thickness of 5 to 6 µm. Then, using an i-line stepper (manufactured by Canon Inc., trade name "FPA-3000iW"), the photosensitive layer was subjected to reduction projection exposure with i-line (365 nm) through a mask having a pattern corresponding to a through-hole having a width of 5 µm. The exposure amount of i-line was 1000 mJ/cm². After the exposure, a part of the photosensitive layer was removed by development using a TMAH aqueous solution having a concentration of 2.38 mass%. The development time with the TMAH aqueous solution was adjusted to a time during which a through-hole could be formed when the exposure amount was 1000 mJ/cm². The film thickness of the insulating resin film as the remaining photosensitive layer was measured, and the residual film ratio (%), which is the ratio of the value to the film thickness of the photosensitive layer before exposure, was calculated.

### Glass Transition Temperature (Tg)

The photosensitive resin composition was applied onto a silicon substrate by spin coating. The coating film was heated at 120°C for 3 minutes to form a photosensitive layer having a film thickness of 8 to 9 µm. The photosensitive layer was then exposed at all wavelengths through a mask using an aligner (manufactured by SUSS MicroTec SE, trade name "MA-8"). The exposure amount was 1500 mJ/cm². After the exposure, an insulating resin film having a pattern including a linear portion having a width of 10 mm was formed by development using a 2.38% TMAH aqueous solution. Using an inert gas oven (INH-9CD-S), the formed insulating resin film was heated to 230°C over 1 hour in a nitrogen atmosphere and maintained at 230°C for 2 hours to advance curing of the insulating resin film. The cured film, which was an insulating resin film after heating, had a thickness of about 7 µm.

The glass transition temperature (Tg) of the formed cured film was measured by thermomechanical analysis using TMA/7100 (manufactured by Hitachi High-Tech Corporation). The sample used for the measurement had a size of 4 mm in width and about 7 µm in film thickness. Measurement conditions were as follows.
Distance between chucks: 10 mm
Load: 10 gf
Heating rate: 5°C/min

**Table 1**

| | | Example | | | | | | | Comparative Example | | | |
|---|---|---|---|---|---|---|---|---|---|---|---|---|
| | | 1 | 2 | 3 | 4 | 5 | 6 | 7 | 1 | 2 | 3 | 4 |
| (A) | A1 | 100 | - | - | - | 100 | 100 | 100 | 100 | 100 | - | - |
| | A2 | - | 100 | - | - | - | - | - | - | - | 100 | - |
| | A3 | - | - | 100 | - | - | - | - | - | - | - | - |
| | A4 | - | - | - | 100 | - | - | - | - | - | - | - |
| | A'1 | - | - | - | - | - | - | - | - | - | - | 100 |
| (B) | B | 18 | 18 | 18 | 18 | 18 | 16 | 20 | - | - | - | 18 |
| | B'1 | - | - | - | - | - | - | - | 18 | 10 | 18 | - |
| (C) | C1 | 25 | 25 | 25 | 25 | - | 25 | 25 | 25 | 25 | 25 | 25 |
| | C2 | - | - | - | - | 25 | - | - | - | - | - | - |
| (D) | D1 | 1 | 1 | 1 | 1 | 1 | 1 | 1 | 1 | 1 | 1 | 1 |
| Via resolution | | 2 | 2 | 2 | 2 | 2 | 2 | 2 | 8 | 2 | 10 | 2 |
| Pattern angle [degree] | | 78 | 78 | 77 | 76 | 78 | 75 | 79 | 78 | 70 | 75 | 73 |
| Development residual film ratio [%] | | 97 | 97 | 96 | 95 | 97 | 95 | 99 | 96 | 87 | 96 | 93 |
| Tg [°C] | | 240 | 244 | 253 | 235 | 238 | 241 | 239 | 238 | 239 | 242 | 207 |

As shown in Table 1, it has been confirmed that the photosensitive resin composition of Examples containing (A) an alkali-soluble resin having a phenolic hydroxyl group and an imide group, (B) a photoacid generator, and (C) a thermal crosslinking agent, in which the photoacid generator contains a compound represented by the Formula (I), can form an insulating resin film having a pattern having a favorable shape with high resolution. The photosensitive resin composition of Examples was also excellent in terms of the residual film ratio after development and heat resistance.

### Reference Signs List

- 10: semiconductor chip

- 11: chip main body
- 12: pad portion
- 13: protective film
- 20: wiring portion
- 31: conductor wiring layer
- 32: connection surface
- 33: barrier metal
- 41: surface protective layer (insulating layer)
- 42: cover coating layer (insulating layer)
- 50: conductive ball
- 100: semiconductor device

## Claims

1. A positive photosensitive resin composition comprising:
(A) an alkali-soluble resin having a phenolic hydroxyl group and an imide group;
(B) a photoacid generator being a compound that generates an acid by light; and
(C) a thermal crosslinking agent being a compound that crosslinks the alkali-soluble resin by heat,
wherein the photoacid generator comprises an o-quinonediazide compound represented by the following Formula (I): 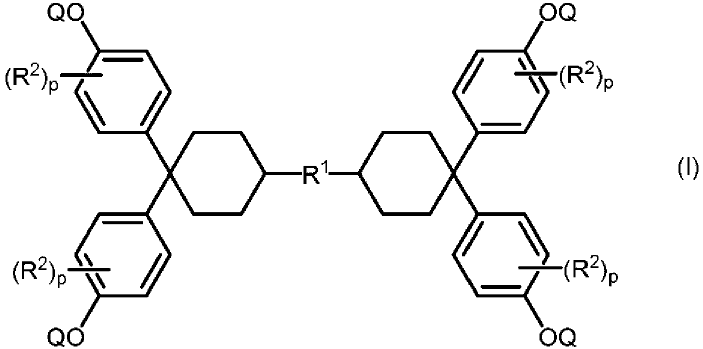
wherein R¹ is an alkanediyl group having 1 to 3 carbon atoms,
R² is an alkyl group having 1 to 3 carbon atoms, p is an integer of 0 to 4, and a plurality of R² in the same molecule may be the same or different,
Q is a group represented by the following Formula (3a), (3b), or (3c): 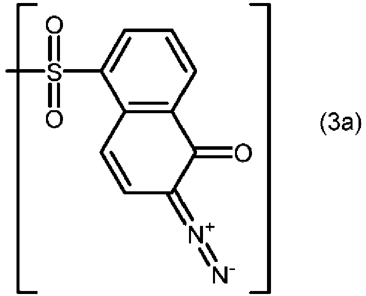 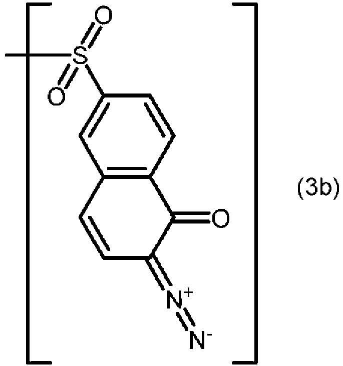 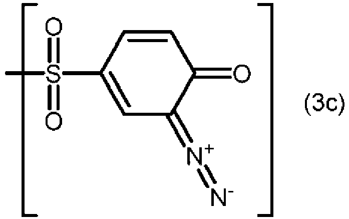
or a hydrogen atom, wherein a plurality of Q in the same molecule may be the same or different, and at least one of the plurality of Q in the same molecule is a group represented by Formula (3a), (3b), or (3c).

2. The positive photosensitive resin composition according to claim 1, wherein
the alkali-soluble resin comprises a constituent unit that is a group obtained by removing one or more hydrogen atoms from a bisphenolimide compound represented by the following Formula (II): 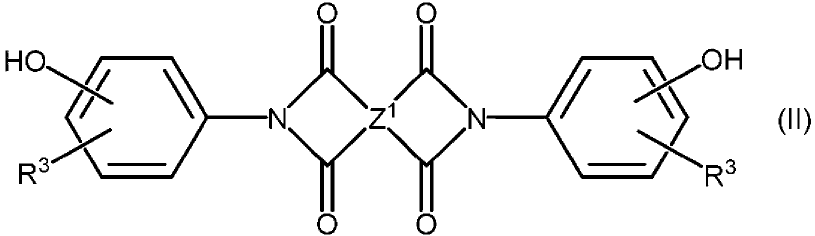
wherein R³ is a hydrogen atom or an alkyl group having 1 to 3 carbon atoms, and Z¹ is a tetravalent organic group.

3. The positive photosensitive resin composition according to claim 1, wherein the thermal crosslinking agent comprises an alkoxy compound having a plurality of alkoxy groups.

4. The positive photosensitive resin composition according to claim 1, wherein, when a portion corresponding to a through-hole having a width of 5 to 20 µm in a photosensitive layer having a film thickness of 5 µm is exposed, the photosensitive layer comprising the positive photosensitive resin composition, and the photosensitive layer after the exposure is developed under conditions that the through-hole is formed with a tetramethylammonium hydroxide aqueous solution having a concentration of 2.38 mass% at an exposure amount of 1000 mJ/m², a film thickness of the remaining photosensitive layer is 95% or more of a film thickness of the photosensitive layer before exposure.

5. A method for forming an insulating resin film, the method comprising:
exposing a part of a photosensitive layer comprising the positive photosensitive resin composition according to any one of claims 1 to 4;
forming an insulating resin film having a pattern including an opening by development for removing a part of the photosensitive layer; and
heating the insulating resin film.

6. An insulating resin film comprising a cured product of the positive photosensitive resin composition according to any one of claims 1 to 4 and having a pattern including an opening.

7. A semiconductor device comprising:
a semiconductor chip; and
a wiring portion comprising a conductor wiring layer connected to the semiconductor chip and one or more insulating layers,
wherein at least a part of the one or more insulating layers is the insulating resin film according to claim 6.
